# EUROPEAN PATENT SPECIFICATION

(11) **EP 2 584 704 B1**
(45) Date of publication and mention of the grant of the patent: **09.01.2019**
(21) Application number: 11188001.9
(22) Date of filing: 07.11.2011
(51) Int. Cl.: H03K 17/96, F24C 7/08

(54) **A control knob for a household appliance**
Steuertaste für ein Haushaltsgerät
Bouton de commande d'appareil domestique

(30) Priority: 17.10.2011 EP 11185381
(43) Date of publication of application: 24.04.2013
(73) Proprietor: Electrolux Home Products Corporation N.V., 1130 Brussels (BE)
(72) Inventor: Rauh, Dominik, 91541 Rothenburg ob der Tauber (DE)
(74) Representative: Electrolux Group Patents

(56) References cited:
- EP-A1- 2 166 669
- US-A1- 2001 008 237
- US-A1- 2011 148 775

## Description

The present invention relates to a control knob for a household appliance, in particular a cooking appliance, according to the preamble of claim 1. Further, the present invention relates to a control device for a household appliance, in particular a cooking appliance, with at least one control knob. Moreover, the present invention relates to a household appliance, in particular a cooking appliance, including a control device with at least one control knob.

Rotary control knobs are a common way for setting cooking levels and for selecting cooking functions. The rotary control knobs are provided for cooking hobs as well as for cooking ovens. The rotary control knobs have a cylindrical form and are revolving around their symmetry axis. However, the rotary control knobs require a pivot bearing in order to allow the rotation around their symmetry axis. The pivot bearing has a relative complex mechanic. Further, the rotary control knobs require an electronic control circuit in order to detect the angle.

WO 2010/121950 A1 discloses a control knob for a domestic appliance. The control knob comprises a number of sensor elements. Said sensor elements are touch sensors or proximity sensors. The sensor elements are electrically insulated from each other and connected to an evaluation circuit. The control knob is a stationary component of a control device. Thus, a mechanical rotation of the control knob is not provided and not necessary. However, it is difficult to allow a reliable switch-off and switch-on of the domestic appliance. Further, an inadvertent switch-off and switch-on of the domestic appliance cannot be confidently prevented.

EP 2 166 669 A1 discloses a control knob for an appliance. The control knob includes a cylindrical surface area and a face side. Touch sensitive sensors are arranged around the cylindrical surface area. The control knob is movable along its symmetry axis relative to a control device. A display element is arranged on the cylindrical surface area.

US 2011/0148775 A1 discloses a display of a touch control area on a cooking hob. The display comprises a plurality of light emitting elements forming an annular bar graph. A numerical display is arranged within said annular bar graph. The annular bar graph displays information graphically, while the numerical display simultaneously indicates the same information numerically.

US 2001/0008237 A1 discloses a control unit for an electrical cooking appliance. The control unit comprises an operating unit and a docking device for receiving said operating unit. The operating unit and docking device are wirelessly connected by transmission means, when said operating unit is received by the docking device. The operating unit is supplied with power via said transmission means. A control-effective connection is only possible, if the operating unit is in the docking device.

It is an object of the present invention to provide a control knob for a household appliance, in particular a cooking appliance, wherein said control knob allows a reliable switch-off and switch-on of the household (or: domestic) appliance and informs the user about the status of said household appliance.

The object of the present invention is achieved by the control knob according to claim 1.

According to the present invention the side on which the at least one display element is arranged is the face side of said control knob, a component and/or the appliance itself is switched off by moving the control knob into the control device, the component and/or the appliance itself is switched on by moving the control knob out of the control device, and a rear sensor element is arranged in a rear portion of the curved cylindrical surface area, which is provided for switching on and off a cooking zone or an oven cavity of the cooking appliance, wherein said rear sensor element is a touch sensor or proximity sensor and formed as an elongated sensor element and has the form of a strip enclosing at least partially the curved cylindrical surface area in the circumference direction.

The main idea of the control knob according to the present invention is that the control knob is movable along its symmetry axis, but not revolvable around said symmetry axis on the one hand. On the other hand, one or more display elements are arranged on the face side of said control knob. The sensor elements on the curved cylindrical surface area allow that the control knob need not be rotatable around its symmetry axis relative to the control device.

According to a preferred embodiment of the present invention the household appliance is a cooking appliance and the control knob corresponds to or with a component of the household appliance or the household appliance as a whole, in particular a cooking zone or an oven cavity of the cooking appliance.
Further, the front sensor element may correspond with a level of power and/or temperature of the cooking zone or the oven cavity of the cooking appliance.

The control knob is foldaway inside the control device by moving rearwards along its symmetry axis. In particular, the face side of the control knob is in the same plane as a front panel of the control device, when the control knob is foldaway inside the control device.
According to a preferred embodiment of the present invention a plurality of display elements is arranged on the face side of said control knob, wherein at least a part of said display elements correspond with the front sensor elements and, preferably, indicate the level of power and/or another parameter of the household appliance, in particular a temperature such as the temperature of the cooking zone or the oven cavity of the cooking appliance.
Further, at least one display element on the face side of said control knob may be provided for indicating an on-off status of the cooking zone, the oven cavity and/or the cooking appliance itself or, in general, a component of the household appliance or the household appliance as a whole.
The cooking zone, the oven cavity and/or the cooking appliance itself or, in general, a component of the household appliance or the household appliance as a whole is switched off by moving the control knob into the control device.

Alternatively, a safety function is activated by moving the control knob into the control device. For example, the safety function is a child-proof lock.

Further, the component of the household appliance or the household appliance as a whole, in particular the cooking zone, the oven cavity and/or the cooking appliance itself, is switched on by moving the control knob out of the control device.

For example, the control knob comprises or corresponds with a spring mechanism for moving said control knob out of the control device by pushing manually the face side of the control knob.

In particular, the control knob is not rotatable around its symmetry axis relative to the control device.

Further, the present invention relates to a control device for a household appliance, in particular a cooking appliance with at least one control knob, wherein the control device includes at least one control knob mentioned above.

At last, the present invention relates to a household appliance, in particular a cooking appliance including at least one control device and/or at least one control knob as described above.

Novel and inventive features of the present invention are set forth in the appended claims.

The present invention will be described in further detail with reference to the drawings, in which
- FIG 1: illustrates a schematic perspective view of a control knob for a cooking appliance according to a preferred embodiment of the present invention, and
- FIG 2: illustrates a flat projection of the curved cylindrical surface area of the control knob according to the preferred embodiment of the present invention.

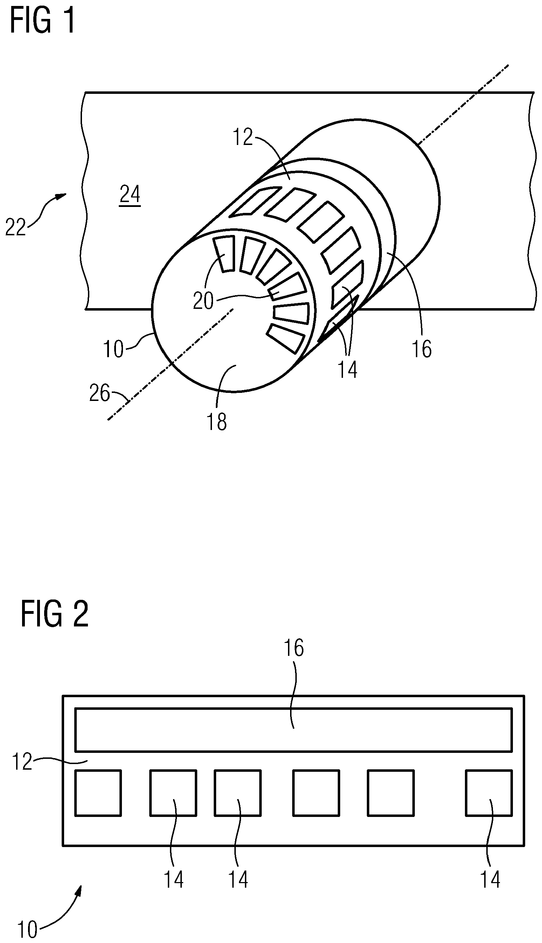

FIG 1 illustrates a schematic perspective view of a control knob 10 for a cooking appliance according to a preferred embodiment of the present invention. The control knob 10 has a cylindrical form.

A plurality of sensor elements 14 and 16 is arranged on the curved cylindrical surface area 12 of the control knob 10. A plurality of display elements 20 is arranged on a face side 18 of the control knob 10.

A number of front sensor elements 14 is arranged in a front portion of said curved cylindrical surface area 12. The front sensor elements 14 form a series enclosing at least partially the front portion of the curved cylindrical surface area 12 in the circumference direction. The front sensor elements 14 correspond with different levels. For example, said levels refer to power or temperature values of a cooking zone or an oven cavity of the cooking appliance.

A rear sensor element 16 is arranged in a rear portion of the curved cylindrical surface area 12. The rear sensor element 16 is formed as an elongated sensor element and has the form of a strip. The rear sensor element 16 encloses at least partially the curved cylindrical surface area 12 in the circumference direction. In this example, the rear sensor element 16 is provided for switching on and off the cooking zone or the oven cavity of the cooking appliance.

For example, the sensor elements 14 and 16 are touch sensors or proximity sensors. The sensor elements 14 and 16 may be sheet elements made of an electrically conductive material, while the proper control knob 10 is made of an insulating material.

The control knob 10 is provided for a control device 22 of a cooking appliance. The control knob 10 is arranged at a front side of the control device 22, if said control device 22 is placed at the front side of the cooking appliance. The control knob 10 is arranged at a top side of the control device 22, if said control device 22 is placed at the top side of the cooking appliance, e.g. on a cooking hob.

The control knob 10 is movable along its symmetry axis 26. In particular, the control knob 10 is foldaway inside the control device 22, so that the face side 18 of the control knob 10 is substantially in the same plane as a front panel 24 of said control device 22. In contrast, the control knob 10 is not revolvable around its symmetry axis 26, so that the control knob 10 does not require a pivot bearing.

When the control knob 10 is foldaway in the control device 22, then either the corresponding cooking zone or oven cavity of the cooking appliance is switched off or a safety function is activated. For example, said safety function is a child-proof lock. Further, the corresponding cooking zone or oven cavity of the cooking appliance may be switched on, when the control knob 10 gets out of the control device 22. However, the switching off by moving the control knob 10 inside the control device 22 is a safety function. The corresponding cooking zone or oven cavity of the cooking appliance may be switched off by touching the rear sensor element 16 or by moving the control knob 10 into the control device 22. In contrast, the switching on by getting the control knob 10 out of the control device 22 is an option. For reasons of safety, the corresponding cooking zone or oven cavity of the cooking appliance may be switched on only by touching the rear sensor element 16.

For example, the control knob 10 comprises a spring mechanism, so that the control knob 10 gets out of the control device 22, when the user pushes at the face side 18 of the control knob 10.

Further, a plurality of display elements 20 is arranged at the face side 18 of the control knob 10. In this example, each display element 20 corresponds with one of the front sensor elements 14. The display elements 20 indicate the activated level of the cooking zone or oven cavity of the cooking appliance.

Additionally or alternatively, a further display element, which in not shown, may be arranged at the face side 18 of the control knob 10. Said further display element indicates the switch-on and switch-off status of the cooking zone or oven cavity of the cooking appliance.
According to another embodiment of the present invention the control knob 10 comprises the plurality of front sensor elements 14, but not the rear sensor element 16. Instead of said rear sensor element 16, the switch-on and switch-off functions of the corresponding cooking zone or oven cavity of the cooking appliance are performed by moving the control knob 10 out of and into the control device 22, respectively. The level of the power and/or temperature is selected by the corresponding front sensor elements 14.
FIG 2 illustrates a flat projection of the curved cylindrical surface area of the control knob 10 according to the preferred embodiment of the present invention. FIG 2 clarifies the arrangement of the front sensor elements 14 and the rear sensor element 16.
In particular, the front sensor elements 14 correspond with different levels of the power or temperature of the cooking zone or oven cavity of the cooking appliance. In this embodiment, the rear sensor element 16 is provided for switching on and off the cooking zone or the oven cavity of the cooking appliance.

The sensor elements 14 and 16 are touch sensors or proximity sensors. The sensor elements 14 and 16 may be sheet elements made of an electrically conductive material, while the proper control knob 10 is made of insulating material.

Although an illustrative embodiment of the present invention has been described herein with reference to the accompanying drawings, it is to be understood that the present invention is not limited to that precise embodiment, and that various other changes and modifications may be affected therein by one skilled in the art without departing from the scope or spirit of the invention. All such changes and modifications are intended to be included within the scope of the invention as defined by the appended claims.

Although embodiments of the invention have been described mainly with regard to the control of cooking appliances, the invention can be applied to any household appliance and the control of the appliance or any component thereof, in particular to laundry washing machines and/or dryers, dish washers, cooling and refrigerating and/or freezing appliances, vacuum cleaners, coffee machines, etc., wherein the parameters can be temperature, power levels, intensity, time or degree of progress or power on/off etc. without any limitation.

### List of reference numerals

- 10: control knob
- 12: curved cylindrical surface area
- 14: front sensor element
- 16: rear sensor element
- 18: face side
- 20: display element
- 22: control device
- 24: front panel
- 26: symmetry axis

## Claims

1. A control knob (10) for a household appliance, in particular a cooking appliance, wherein:
- the control knob (10) includes a curved cylindrical surface area (12) and a face side (18), wherein the face side of the control knob is in a plane which is parallel to a front panel of a control device,
- a plurality of front sensor elements (14) is arranged on the curved cylindrical surface area (12) of the control knob (10), and
- the front sensor elements (14) are tactile sensor elements or proximity sensor elements,
- the control knob (10) is movable along its symmetry axis (26) relative to the control device (22), and
- at least one display element (20) is arranged on a side of said control knob (10),
**characterized in that** the side on which the at least one display element (20) is arranged is the face side (18) of said control knob (10), wherein a component of the appliance and/or the appliance itself is switched off by moving the control knob (10) into the control device (22), the component and/or the appliance itself is switched on by moving the control knob (10) out of the control device (22), and a rear sensor element (16) is arranged in a rear portion of the curved cylindrical surface area (12), which is provided for switching on and off a cooking zone or an oven cavity of the cooking appliance, wherein said rear sensor element (16) is a touch sensor or proximity sensor and is formed as an elongated sensor element and has the form of a strip enclosing at least partially the curved cylindrical surface area (12) in the circumference direction.

2. The control knob according to claim 1, wherein
- the control knob (10) is arranged or arrangeable at a control device (22) of the household appliance, in particular cooking appliance and/or that
- the control knob (10) corresponds to or with a component of the household appliance or the household appliance as a whole, in particular a cooking zone or an oven cavity of the cooking appliance.

3. The control knob according to claim 1 or 2, wherein the front sensor elements (14) correspond with a level of power and/or at least one parameter, in particular a temperature, in particular a temperature of the cooking zone or the oven cavity of the cooking appliance.

4. The control knob according to any one of the preceding claims, wherein the control knob (10) is foldaway inside the control device (22) by moving rearwards along its symmetry axis (26) .

5. The control knob according to claim 4, wherein the face side (18) of the control knob (10) is the same plane as a front panel (24) of the control device (22), when the control knob (10) is foldaway inside the control device (22).

6. The control knob according to any one of the preceding claims, wherein a plurality of display elements (20) is arranged on the face side (18) of said control knob (10), wherein at least a part of said display elements (20) correspond with the front sensor elements (14) and, preferably, indicate the level of power and/or at least one parameter, in particular temperature, in particular of the cooking zone or the oven cavity of the cooking appliance.

7. The control knob according to any one of the preceding claims, wherein at least one display element (20) on the face side (18) of said control knob (10) is provided for indicating an on-off status of the component, in particular the cooking zone or the oven cavity, and/or of the household appliance, in particular the cooking appliance, itself.

8. The control knob according to any one of the preceding claims, wherein the control knob (10) comprises or corresponds with a spring mechanism for moving said control knob (10) out of the control device (22) by pushing manually the face side (18) of the control knob (10).

9. The control knob according to any one of the preceding claims, wherein the control knob (10) is not rotatable around its symmetry axis (26) relative to the control device (22).

10. A control device (22) for a household appliance, in particular a cooking appliance, with at least one control knob (10), wherein the control device (22) includes at least one control knob (10) according to any one of the claims 1 to 9.

11. A household appliance, in particular a cooking appliance, with at least one component, in particular a cooking zone and/or oven cavity and at least one control device (22) for one or more components, in particular cooking zones and/or oven cavities, wherein the household appliance includes at least one control knob (10) according to any one of the claims 1 to 9 at least one control device (22) according to claim 10.

## Patentansprüche

1. Steuerknopf (10) für ein Haushaltsgerät, insbesondere ein Kochgerät, wobei:
- der Steuerknopf (10) eine gekrümmte zylindrische Oberfläche (12) und eine Stirnseite (18) beinhaltet, wobei die Stirnseite des Steuerknopfes in einer Ebene liegt, die parallel zu einem Frontpaneel der Steuervorrichtung liegt,
- eine Vielzahl von vorderen Sensorelementen (14) auf der gekrümmten zylindrischen Oberfläche (12) des Steuerknopfes (10) angeordnet ist und
- die vorderen Sensorelemente (14) taktile Sensorelemente oder Näherungssensorelemente sind,
- der Steuerknopf (10) entlang seiner Symmetrieachse (26) relativ zur Steuervorrichtung (22) bewegbar ist und
- mindestens ein Anzeigeelement (20) auf einer Seite des Steuerknopfes (10) angeordnet ist,
**dadurch gekennzeichnet, dass**
die Seite, auf der das mindestens eine Anzeigeelement (20) angeordnet ist, die Stirnseite (18) des Steuerknopfes (10) ist, wobei
eine Komponente des Geräts und/oder das Gerät selbst durch Bewegen des Steuerknopfes (10) in die Steuervorrichtung (22) ausgeschaltet wird, die Komponente und/oder das Gerät selbst durch Bewegen des Steuerknopfes (10) aus der Steuervorrichtung (22) heraus eingeschaltet wird und ein hinteres Sensorelement (16) in einem hinteren Abschnitt der gekrümmten zylindrischen Oberfläche (12) angeordnet ist, das zum Ein- und Ausschalten eines Kochbereichs oder eines Ofenhohlraums des Kochgeräts bereitgestellt ist, wobei das hintere Sensorelement (16) ein Berührungssensor oder ein Näherungssensor ist und als ein längliches Sensorelement gebildet ist und die Form eines Streifens aufweist, der mindestens teilweise die gekrümmte zylindrische Oberfläche (12) in der Umfangsrichtung umschließt.

2. Steuerknopf nach Anspruch 1,
wobei
- der Steuerknopf (10) an der Steuervorrichtung (22) des Haushaltsgeräts, insbesondere Kochgerät, angeordnet oder anordenbar ist und/oder
- der Steuerknopf (10) einer Komponente des Haushaltsgeräts oder dem Haushaltsgerät als Ganzem, insbesondere einem Kochbereich oder einem Ofenhohlraum des Kochgeräts entspricht.

3. Steuerknopf nach Anspruch 1 oder 2,
wobei
die vorderen Sensorelemente (14) einem Leistungspegel und/oder mindestens einem Parameter, insbesondere einer Temperatur, insbesondere einer Temperatur des Kochbereichs oder des Ofenhohlraums des Kochgeräts entsprechen.

4. Steuerknopf nach einem der vorhergehenden Ansprüche,
wobei
der Steuerknopf (10) durch Bewegen nach hinten entlang seiner Symmetrieachse (26) in der Steuervorrichtung (22) versenkbar ist.

5. Steuerknopf nach Anspruch 4,
wobei
die Stirnseite (18) des Steuerknopfes (10) in derselben Ebene wie ein Frontpaneel (24) der Steuervorrichtung (22) liegt, wenn der Steuerknopf (10) in der Steuervorrichtung (22) versenkt ist.

6. Steuerknopf nach einem der vorhergehenden Ansprüche,
wobei
eine Vielzahl von Anzeigeelementen (20) auf der Stirnseite (18) des Steuerknopfes (10) angeordnet ist, wobei mindestens ein Teil der Anzeigeelemente (20) den vorderen Sensorelementen (14) entsprechen und vorzugsweise den Leistungspegel und/oder mindestens einen Parameter, insbesondere eine Temperatur, insbesondere des Kochbereichs oder des Ofenhohlraums des Kochgeräts anzeigen.

7. Steuerknopf nach einem der vorhergehenden Ansprüche,
wobei
mindestens ein Anzeigeelement (20) auf der Stirnseite (18) des Steuerknopfes (10) zum Anzeigen eines Ein-Aus-Status der Komponente, insbesondere des Kochbereichs oder des Ofenhohlraums, und/oder des Haushaltsgeräts, insbesondere des Kochgeräts, selbst bereitgestellt ist.

8. Steuerknopf nach einem der vorhergehenden Ansprüche,
wobei
der Steuerknopf (10) einen Federmechanismus zum Bewegen des Steuerknopfes (10) aus der Steuervorrichtung (22) heraus durch manuelles Drücken der Stirnseite (18) des Steuerknopfes (10) umfasst oder diesem entspricht.

9. Steuerknopf nach einem der vorhergehenden Ansprüche,
wobei
der Steuerknopf (10) um seine Symmetrieachse (26) relativ zur Steuervorrichtung (22) nicht drehbar ist.

10. Steuervorrichtung (22) für ein Haushaltsgerät, insbesondere ein Kochgerät, mit mindestens einem Steuerknopf (10),
wobei
die Steuervorrichtung (22) mindestens einen Steuerknopf (10) nach einem der Ansprüche 1 bis 9 beinhaltet.

11. Haushaltsgerät, insbesondere ein Kochgerät, mit mindestens einer Komponente, insbesondere einem Kochbereich und/oder einem Ofenhohlraum und mindestens einer Steuervorrichtung (22) für eine oder mehrere Komponenten, insbesondere Kochbereiche und/oder Ofenhohlräume,
wobei
das Haushaltsgerät mindestens einen Steuerknopf (10) nach einem der Ansprüche 1 bis 9 und mindestens eine Steuervorrichtung (22) nach Anspruch 10 beinhaltet.

## Revendications

1. Bouton de commande (10) d'un appareil ménager, en particulier d'un appareil de cuisson, dans lequel :
le bouton de commande (10) comprend une surface cylindre incurvée (12) et une face avant (18), la face avant du bouton de commande étant dans un plan parallèle à un panneau avant d'un dispositif de commande,
une pluralité d'éléments capteurs avant (14) sont disposés sur la surface cylindrique incurvée (12) du bouton de commande (10), et
les éléments capteurs avant (14) sont des éléments capteurs tactiles ou des éléments capteurs de proximité,
le bouton de commande (10) est mobile le long de son axe de symétrie (26) par rapport au dispositif de commande (22), et
au moins un élément d'affichage (20) est disposé sur un côté dudit bouton de commande (10),
le bouton de commande étant **caractérisé en ce que** :
le côté sur lequel l'au moins un élément d'affichage (20) est disposé est la face avant (18) dudit bouton de commande (10),
un composant de l'appareil et/ou l'appareil lui-même sont éteints en déplaçant le bouton de commande (10) dans le dispositif de commande (22), le composant et/ou l'appareil lui-même sont allumés en déplaçant le bouton de commande (10) hors du dispositif de commande (22), et un élément capteur arrière (16) est disposé dans une partie arrière de la surface cylindrique incurvée (12) et permet d'allumer et d'éteindre une zone de cuisson ou une cavité de four de l'appareil de cuisson, ledit élément capteur arrière (16) étant un capteur tactile ou un capteur de proximité se présentant sous la forme d'un élément capteur allongé ayant la forme d'une bande enfermant, au moins en partie, la surface cylindrique incurvée (12) dans le sens de la circonférence.

2. Bouton de commande selon la revendication 1, dans lequel :
le bouton de commande (10) est disposé ou peut être disposé au niveau d'un dispositif de commande (22) de l'appareil ménager, en particulier de l'appareil de cuisson, et/ou
le bouton de commande (10) correspond à un composant de l'appareil ménager ou à l'appareil ménager dans son ensemble, en particulier à une zone de cuisson ou à une cavité de four de l'appareil de cuisson.

3. Bouton de commande selon la revendication 1 ou 2, dans lequel :
les éléments capteurs avant (14) correspondent à un niveau de puissance et/ou à au moins un paramètre, en particulier à une température, en particulier à une température de la zone de cuisson ou de la cavité de four de l'appareil de cuisson.

4. Bouton de commande selon l'une quelconque des revendications précédentes, dans lequel :
le bouton de commande (10) est plié à l'intérieur du dispositif de commande (22) en le déplaçant vers l'arrière le long de son axe de symétrie (26).

5. Bouton de commande selon la revendication 4, dans lequel :
la face avant (18) du bouton de commande (10) est dans le même plan qu'un panneau avant (24) du dispositif de commande (22), quand le bouton de commande (10) est plié à l'intérieur du dispositif de commande (22).

6. Bouton de commande selon l'une quelconque des revendications précédentes, dans lequel :
une pluralité d'éléments d'affichage (20) sont disposés sur la face avant (18) dudit bouton de commande (10), au moins une partie desdits éléments d'affichage (20) correspondant aux éléments capteurs avant (14) et, de préférence, indiquant le niveau de puissance et/ou au moins un paramètre, en particulier une température, en particulier une température de la zone de cuisson ou de la cavité de four de l'appareil de cuisson.

7. Bouton de commande selon l'une quelconque des revendications précédentes, dans lequel :
au moins un élément d'affichage (20) sur la face avant (18) dudit bouton de commande (10) permet d'indiquer un statut de marche-arrêt du composant, en particulier de la zone de cuisson ou de la cavité de four, et/ou de l'appareil ménager, en particulier de l'appareil de cuisson lui-même.

8. Bouton de commande selon l'une quelconque des revendications précédentes, dans lequel :
le bouton de commande (10) comprend ou correspond à un mécanisme de ressort pour déplacer ledit bouton de commande (10) hors du dispositif de commande (22) en appuyant manuellement sur la face avant (18) du bouton de commande (10).

9. Bouton de commande selon l'une quelconque des revendications précédentes, dans lequel :
le bouton de commande (10) n'est pas rotatif autour de son axe de symétrie (26) par rapport au dispositif de commande (22).

10. Dispositif de commande (22) d'un appareil ménager, en particulier d'un appareil de cuisson, comportant au moins un bouton de commande (10), dans lequel :
le dispositif de commande (22) comprend au moins un bouton de commande (10) selon l'une quelconque des revendications 1 à 9.

11. Appareil ménager, en particulier appareil de cuisson, composant au moins un composant, en particulier une zone de cuisson et/ou une cavité de four, et au moins un dispositif de commande (22) d'un ou plusieurs composants, en particulier de zones de cuisson et/ou de cavités de four, dans lequel :
l'appareil ménager comprend au moins un bouton de commande (10) selon l'une quelconque des revendications 1 à 9 et au moins un dispositif de commande (22) selon la revendication 10.
